# EUROPEAN PATENT APPLICATION

(11) **EP 4 057 460 A1**
(43) Date of publication of application: **14.09.2022**
(21) Application number: 22161451.4
(22) Date of filing: 10.03.2022
(51) Int. Cl.: H02G 3/06, H01R 13/58

(54) **COMPONENT FOR ATTACHING A CABLE TO A HOUSING MEMBER**

(30) Priority: 11.03.2021 DE 102021105894
(71) Applicant: TE Connectivity Germany GmbH, 64625 Bensheim (DE); TE Connectivity India Private Limited, Bangalore 560048 (IN)
(72) Inventor: Ripper, Hartmut, 64625 Bensheim (DE); Ashour, Yehya, 64625 Bensheim (DE); Kumar S, Vinoth, 560048 Bangalore (IN)
(74) Representative: Grünecker Patent- und Rechtsanwälte PartG mbB

(57) **Abstract**

A component (10) for attaching a cable (90) to a housing member (50) is shown comprising an attachment section (20) with at least one attachment element (21) and a tubular cable clamping section (30) that is connected integrally to the attachment section (20) and that forms a cable tunnel (35), wherein the cable clamping section (30) comprises at least one clamping tongue (31) that may be deflected into the cable tunnel (35). Furthermore, a housing assembly (100) with such a component (10) and a connection assembly (200) with such a component (10) are shown.

## Description

The invention relates to a component for attaching a cable to a housing member. The housing member and the component may be parts of a housing assembly which may be used to attach the cable to an external element, for example, to a ground connection. Such systems are used, for example, in automobiles.

However, previous systems are difficult to assemble and are prone to assembly errors.

The object of the invention is to provide a solution that makes the assembly simple and safe.

This is satisfied according to the invention by a component for attaching a cable to a housing member, comprising an attachment section with at least one attachment element and a tubular cable clamping section that is connected integrally to the attachment section and that forms a cable tunnel, where the cable clamping section comprises at least one clamping tongue that may be deflected into the cable tunnel.

The attachment section allows for reliable attachment to the housing member. The cable may be guided in the cable tunnel, where the cable may be movable when the clamping tongue is not deflected into the cable tunnel. This allows for the cable and the connection to be adjusted. When the adjustment has been made, the clamping tongue may be deflected into the cable tunnel, whereby the clamping tongue affixes the cable in position Simple assembly is possible with this solution.

The invention may be further improved by the following developments and configurations which are advantageous each by itself and may be combined with one another at random.

The clamping tongue may comprise an inwardly directed clamping projection for improving the retaining effect. The clamping projection may be configured to press or dig into a cable sheath of the cable and thereby achieve a good retaining effect. Destruction of the cable sheath is not intended, rather the cable sheath is merely plastically deformed. A narrow configuration of the clamping projection, for example, as a pin or strip, enables good plastic deformation of the cable sheath with low forces at the same time. The clamping projection may project into the cable tunnel.

In an embodiment that is easy to manufacture, the clamping projection may be arranged at a free end of the clamping tongue.

A strap-shaped or belt-shaped clamping element may be used for applying a clamping force. The clamping element may be affixable in a clamping state. In particular a cable tie may be used as a clamping element. A cable tie is presently to mean in particular an element with a belt-shaped toothed section and a head connected thereto in which the belt-shaped section may be affixed in a ratchet-like manner. The fixation may be repeatedly releasable or not be non-destructively releasable.

In order to be able to receive such a clamping element and to be able to retain it in a desired position, the clamping tongue may have a guide groove running along a circumferential direction of the cable clamping section on an outer side. The guide groove may be defined or formed by two guide strips which are spaced apart from one another and project from the remainder of the clamping tongue. Such a guide groove does not need to be present on the remainder of the clamping section.

In order to enable, for example, easy operation, the clamping tongue may be manipulated from the exterior. For this purpose, the clamping tongue may project at least in sections from an outer wall of the cable clamping section. This may be the case in particular in an adjustment state or a resting state, where the resting state may be a forceless state in which no forces act upon the clamping tongue. An adjustment state may be a state in which the clamping element does not yet clamp the clamping tongue sufficiently and an adjustment of the cable is then still possible.

In an advantageous embodiment, a radial cross section of the clamping section in the region of the clamping tongue is configured to deflect the clamping tongue inwardly at most by a predefined value when the clamping element is attached. This may prevent damage to the cable sheath or excessive clamping force. The predefined value may correspond to a degree of the projection or be in a defined relationship therewith. For example, it may correspond to a degree of the projection in the region of a guide strip minus the height of the guide strip in relation to a base of the guide groove.

In particular, the clamping tongue may be deflected inwardly at most by a predefined value when it forms a circular outer circumference with the remainder of the clamping section. When using a strap-shaped or belt-shaped clamping element, it may then simply be lashed down until it is in complete abutment. The clamping tongue or the clamping projection may then automatically be deflected to the maximum degree such that they do not damage the sheath of the cable.

The clamping section may comprise a breakthrough which frames the clamping tongue. This may stabilize the clamping section. Furthermore, this may improve the retaining effect and limit the maximum clamping force.

In order to keep the configuration compact, the clamping tongue may extend parallel to an axial direction. The axial direction may be in particular a direction along which the cable tunnel extends through the clamping section.

In order to obtain good fixation, the clamping tongue may be oriented with a free end towards an end of the component on the cable side.

If there are two clamping tongues present opposite one another along a radial direction, then the clamping force may be well distributed. In another configuration, there may also be more than two clamping tongues present. They are then distributed preferably uniformly along the circumference on the clamping section.

For a good sealing effect and for receiving a cylindrical cable, the cable tunnel may have a substantially cylindrical cross section.

For simple and reliable attachment, the attachment element may be a latching element. In particular, the attachment element may be a latching tab or a latching hook.

In order to enable the cable to be inserted easily, the clamping tongue may not project into the cable tunnel in a resting state. In the resting state, the clamping tongue may be free of force.

In an alternative embodiment, the clamping tongue, in particular a clamping projection, may be configured such that the cable may be easily inserted. For example, the clamping projection may be rounded or have bevels. They may cause the clamping tongue to automatically deflect when the cable is inserted.

For precise adjustment with respect to the housing member, the component may have an inner stop surface extending perpendicular to an axial direction.

The present invention further relates to a housing assembly. The housing assembly according to the invention may comprise a component according to the invention and a housing member with a chamber and a cable receptacle connected to the chamber, where the cable receptacle is configured to be connected to the component.

In an advantageous embodiment, the chamber is open along a pin receiving direction. The cable receptacle may be open along a cable receiving direction that is perpendicular to the pin receiving direction. Open presently means in particular in the non-assembled state when the openings are not yet closed by other components. The vertical arrangement facilitates in particular an adjustment of the cable relative to a pin which is inserted into the chamber, preferably in the pin receiving direction.

The housing member preferably comprises at least one attachment element which interacts with the attachment element of the component. The attachment element of the housing member may be complementary at least in part to the attachment element of the component. The attachment element may be, for example, a projection or a latching element. The attachment elements, however, may also be configured differently, for example, as a screw and a corresponding hole.

In an advantageous configuration, the cable receptacle and the attachment section comprise positioning sections that are complementary to one another. This enables particularly simple and reliable positioning relative to one another. The positioning sections may be configured in particular in an annular, cylindrical, and/or rotationally symmetrical manner.

The present invention also relates to a connection assembly. The connection assembly according to the invention may comprise a housing assembly according to the invention and a cable, where one end of the cable is provided with a cable lug and is arranged in the housing assembly.

The solution according to the invention enables in particular an adjustment of the cable lug with a dummy pin and a subsequent fixation of the cable. Such a pre-adjustment and pre-assembly when establishing the connection assembly may save time in the subsequent assembly of the connection assembly on the actual pin, since adjustment is then no longer required during this assembly.

A pre-adjusted and affixed connection assembly in which an opening of the cable lug is centered in the chamber is therefore particularly advantageous, where the connection assembly comprises a clamping element which clamps the cable by way of the clamping tongue.

For mounting on an external element, for example, on a pin, the housing assembly may comprise a press-on member. The press-on member may comprise a screw. Furthermore, the press-on member may comprise a manipulation section at which it may be manipulated preferably from the exterior. The press-on member may be arranged at least in part in the chamber.

The housing assembly and the connection assembly may also comprise seals for sealing against dirt and liquids. The seals may be configured such that they only seal when the component is attached or when the press-on member is manipulated.

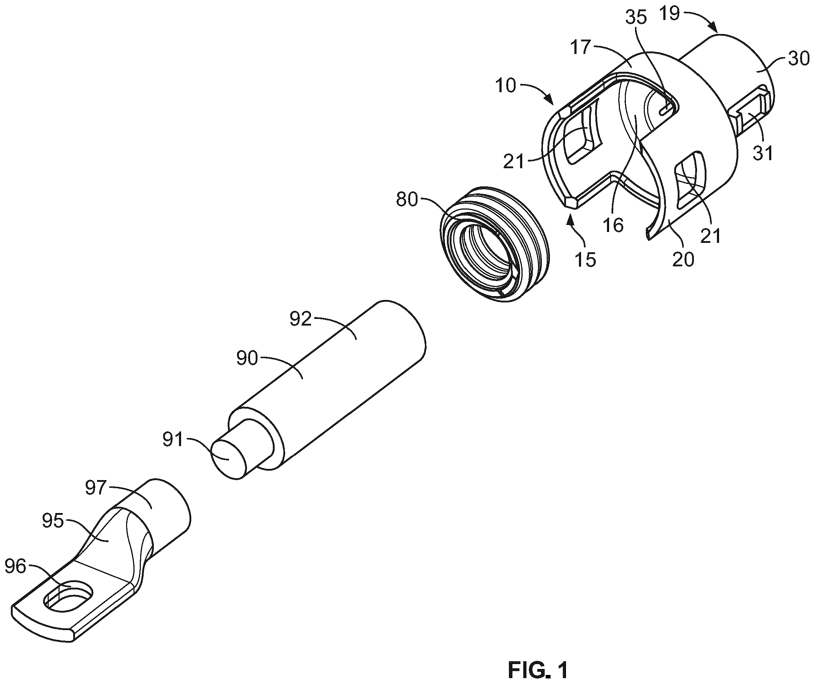

The invention shall be explained in more detail hereafter by way of example on the basis of advantageous configurations with reference to the drawings. The advantageous further developments and configurations shown there are each independent of one another and may be combined with one another at random, depending on how this is necessary for the application, where
- Fig. 1: shows a schematic perspective view of an embodiment of the component together with further elements;

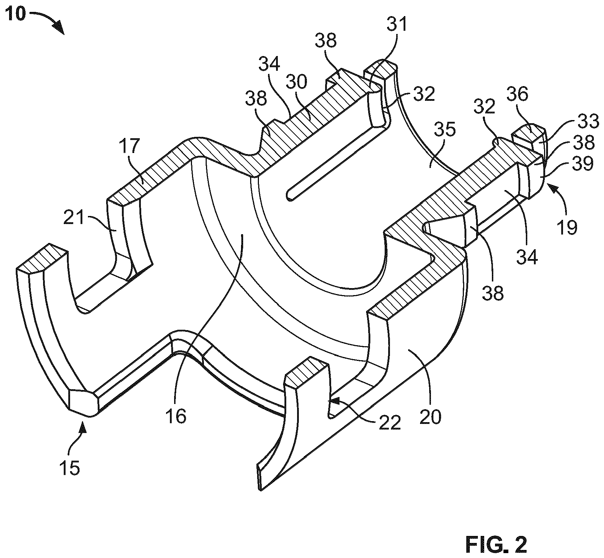

- Fig. 2: shows a schematic partially sectioned perspective view of the embodiment of the component from Figure 1;

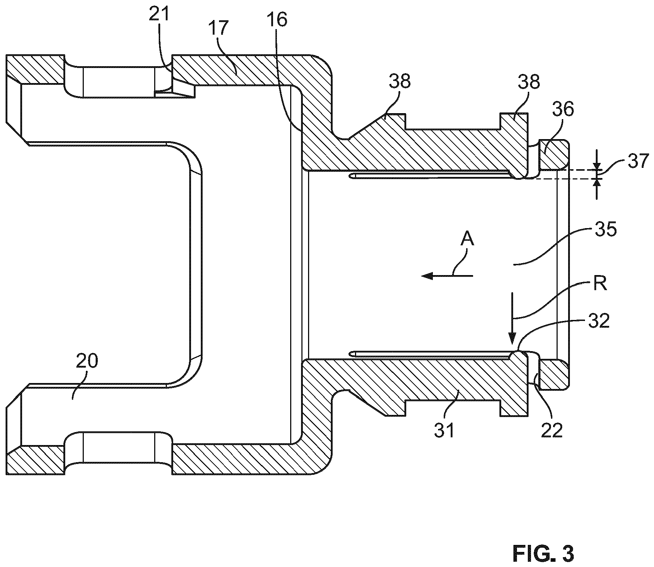

- Fig. 3: shows a schematic partially sectioned side view of the embodiment of the component from Figure 1;

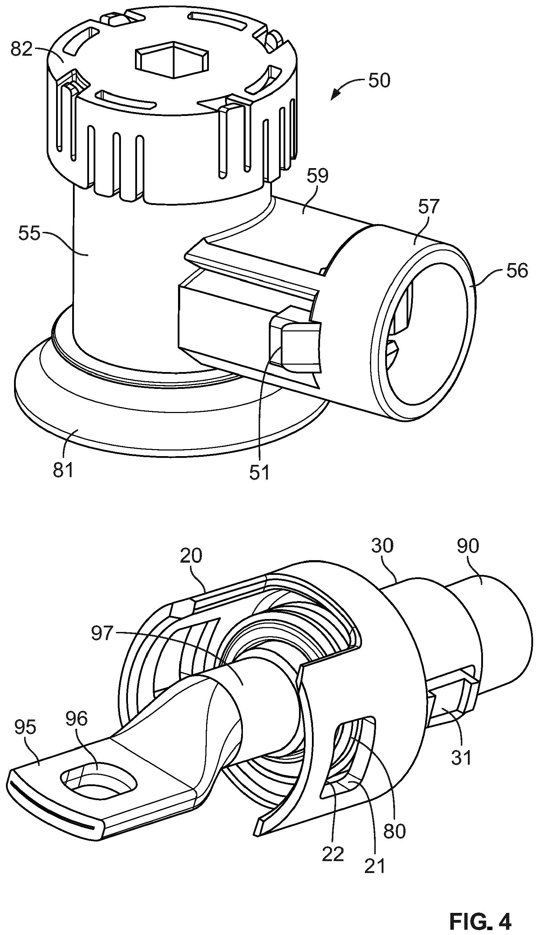

- Fig. 4: shows a schematic perspective view of the component from Figure 1 together with further parts, in particular a housing member;
- Fig. 5: shows a schematic partially sectioned perspective view of a connection arrangement in an adjustment state;
- Fig. 6: shows a schematic partially sectioned side view of a detail of the connection assembly from Figure 5;
- Fig. 7: shows a further schematic partially sectioned side view of a detail of the connection assembly from Figure 5;
- Fig. 8: shows a schematic partially sectioned perspective view of a connection arrangement in a clamping state;
- Fig. 9: shows a schematic partially sectioned side view of a detail of the connection assembly from Figure 8;
- Fig. 10: shows a further schematic partially sectioned side view of a detail of the connection assembly from Figure 8.

A component 10 for attaching a cable 90 to a housing member 50 is shown in the figures. Component 10 comprises an attachment section 20 with several attachment elements 21 and a tubular cable clamping section 30 that is connected integrally to attachment section 20 and that forms a cable tunnel 35. Cable tunnel 35 forms a substantially circular-cylindrical receptacle for cable 90 which has a circular-cylindrical configuration. The size and the shape of cable tunnel 35 are matched to the size and the shape of cable 90 so that cable tunnel 35 guides cable 90 and holds it in a stable manner. Cable 90 may be standardized, in particular according to national or international standards or according to company-specific or proprietary standards.

Cable 90 may be, for example, a ground connection with which a device is connected to a ground potential or an earth potential. Cable 90 then typically comprises a single inner conductor 91 and a sheath 92 that surrounds conductor 91 and is made of insulating material, for example, elastic or plastic material.

A cable lug 95 may be attached to one end of cable 90, for example, by crimping cable lug 95 onto a crimping section 97 on an exposed part of conductor 91. Cable lug 90 further comprises an opening 96 into which a pin 70 may be inserted. Pin 70 may have at a ground potential or an earth potential applied.

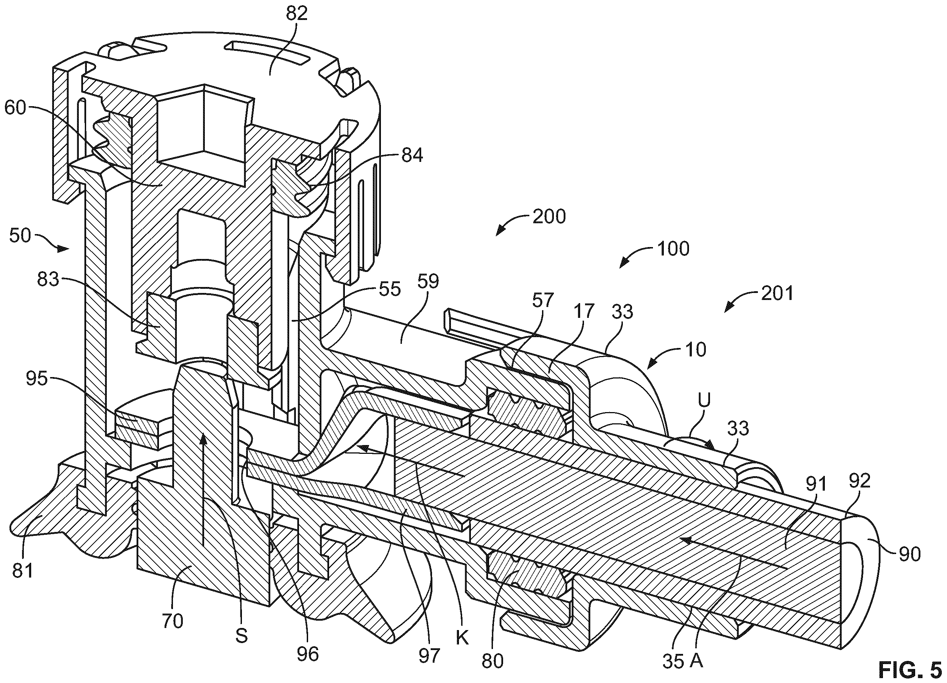

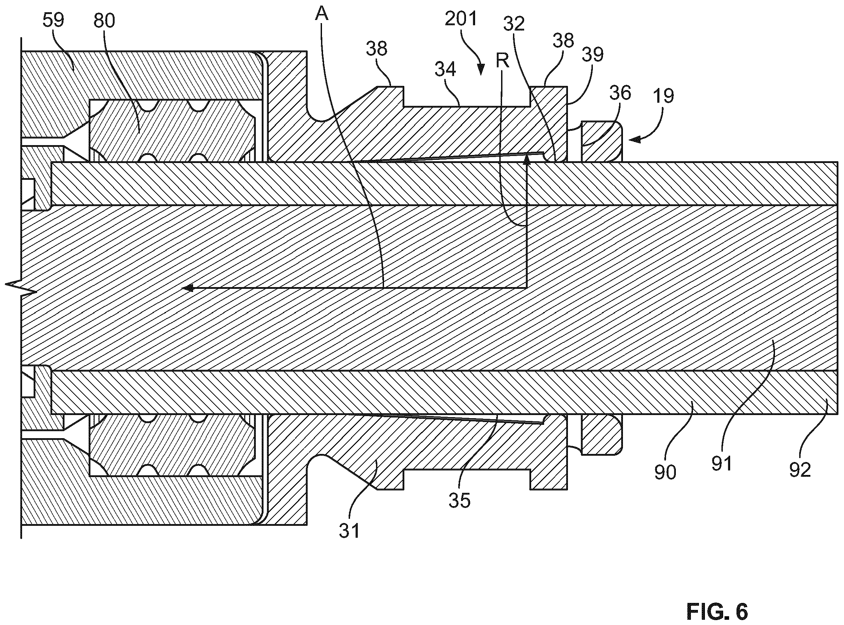

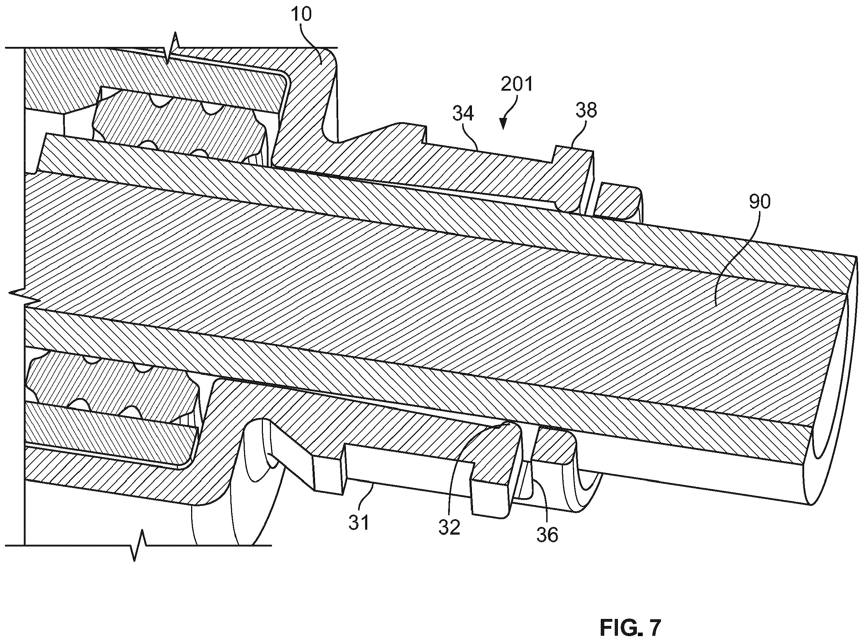

In adjustment position 201 shown in Figures 5, 6 and 7, cable 90 may be displaced and thereby adjusted relative to the remainder of connection assembly 200 in cable receptacle 59 along a cable receiving direction K which runs parallel to an axial direction of cable tunnel 35. In particular, the position of opening 96 may be adjusted. Once cable 90 with cable lug 95 has been inserted In Figure 5 into a chamber 55 of housing assembly 100, a pin 70 in the form of a dummy pin has been inserted into opening 96 along a pin receiving direction S.

For attaching cable 90 in component 10 and affixing the position, cable clamping section 30 comprises at least one clamping tongue 31 which may be deflected into cable tunnel 35. In the example shown, there are two oppositely disposed clamping tongues 31 in order to achieve a good distribution of forces and a good clamping effect. Clamping tongues 31 may there be deflected in and opposite to a radial direction R which runs perpendicular to axial direction A.

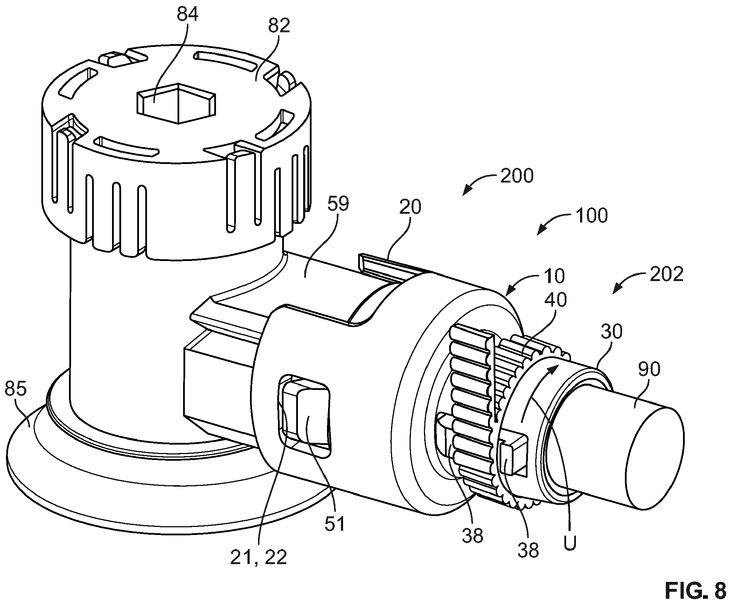

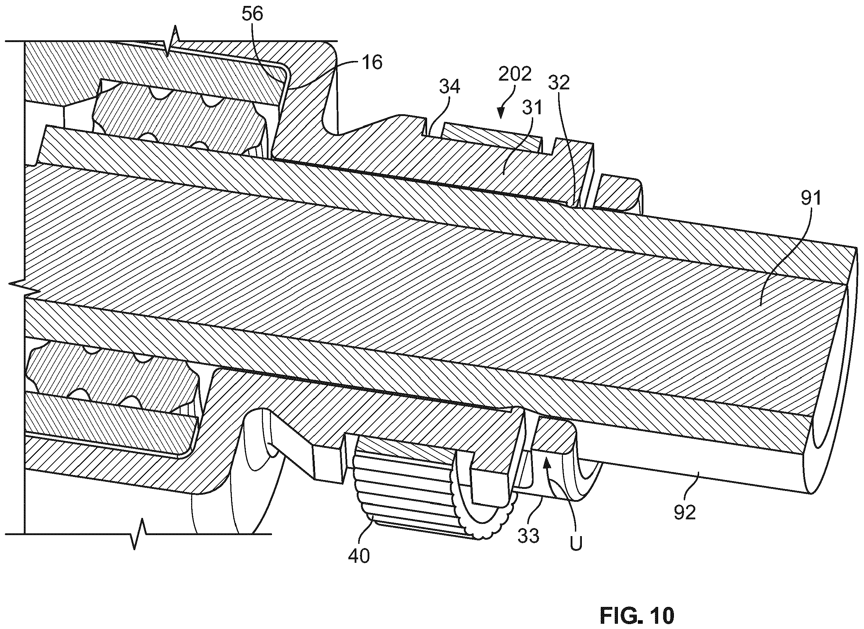

Each of clamping tongues 31 comprises an inwardly directed clamping projection 32 which, when clamping tongue 31 is manipulated, presses into sheath 92 of cable 90 and thereby prevents any movement of cable 90. By manipulating clamping tongue 31, connection assembly 200 then transitions to a clamping state 202 which is shown, for example, in Figures 8, 9 and 10. In clamping state 202, the position of clamping tongue 31 is affixed by a strap-shaped clamping element 40, presently in the form of a cable tie.

In order to lock clamping element 40 against displacement along axial direction A, each clamping tongue 31 on an outer side comprises a guide groove 34 extending along a circumferential direction U of cable clamping section 30. Guide grooves 34 are each defined on both sides by outwardly projecting guide strips 38 running along circumferential direction U.

For simple manipulation, each clamping tongue 31 may be manipulated from the exterior.

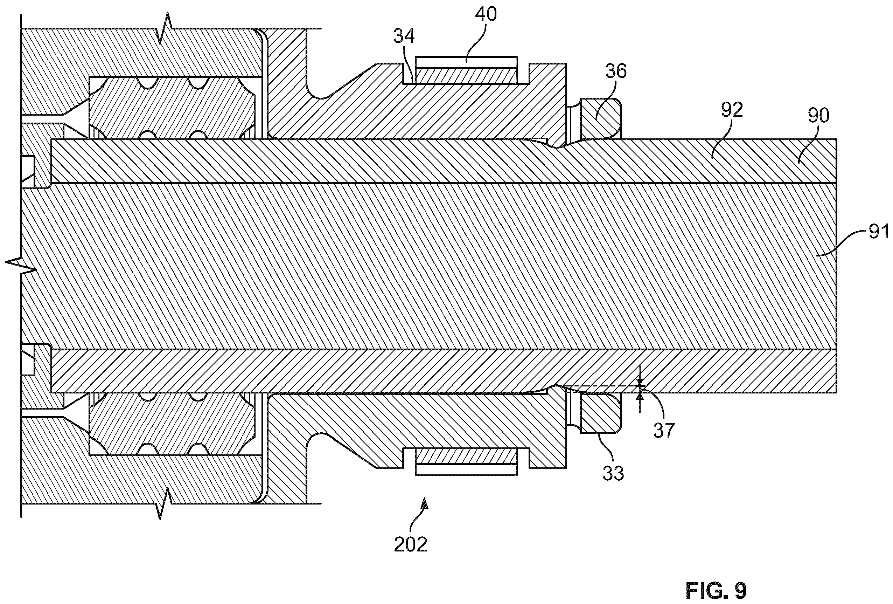

In order to prevent clamping projection 32 from penetrating too deeply into cable sheath 92 and damaging it, a radial cross section of cable clamping section 30 in the region of clamping tongue 31 is configured such that clamping tongue 31 deflects inwardly at most by a predefined value when clamping element 40 is attached. In the embodiment shown, this is achieved in that clamping tongue 31 is deflected inwardly at most by a predefined value when it forms a circular outer circumference with the remainder of cable clamping section 30. As a result, depth 37, shown for example in Figure 9, to which clamping projection 32 penetrates into cable sheath 92 is effectively limited. When the strap-shaped clamping element 40 is attached and lashed to the maximum degree, it then runs in a circle along the outer circumference.

Clamping projections 32 are each beveled along axial direction A in order to facilitate the insertion and displacement of cable 90. Clamping projections 32 are configured as tapering strips with an edge oriented towards cable 90.

Around each of clamping tongues 31, cable clamping section 30 has a breakthrough 36 which frames clamping tongue 31. This stabilizes cable clamping section 30 and clamping tongue 31.

Clamping tongues 31 each extend approximately parallel to an axial direction A and may be deflected perpendicular thereto along radial direction R.

For a good retaining effect, clamping tongues 31 are each oriented with a free end 39 towards an end 19 of component 10 on the cable side.

Attachment elements 21 on component 10 are each shaped as a latching element. They are configured as latching tabs 22 which interact with attachment elements 51 configured as latching projections 52 on housing member 50. In the latched state, an inner stop surface 16, which is arranged on component 10 and extends perpendicular to axial direction A, abuts against a counter-stop surface 56 on housing member 50. For correct positioning along radial direction R, component 10 and housing member 50 each comprise approximately circular ring-shaped positioning sections 17 and 57 which are complementary to one another.

Housing member 50 comprises a chamber 55 and a cable receptacle 59 connected to said chamber 55. Chamber 55 serves in particular to receive pin 70 and cable lug 90 and is open along pin receiving direction S. It has a substantially cylindrical interior. Cable receptacle 59 is configured for being connected to component 10 and is open along cable receiving direction K perpendicular to pin receiving direction S. Cable receptacle 59 is formed integrally with chamber 55. Housing member 50 is, for example, injection-molded from a plastic material.

With the aid of the solution shown, it is possible to adjust and affix connection assembly 200 prior to the actual assembly such that only one pin 70 later needs to be inserted along pin receiving direction S and connection assembly 200 needs to be attached. This is achieved in particular in that the position of opening 96 is adjusted with a dummy pin prior to the actual assembly and cable 90 is thereafter affixed. After this adjustment and the removal of the dummy pin, opening 96 of cable lug 95 is centered in chamber 55 and cable 90 is clamped by way of clamping tongue 31. Due to such pre-adjustment and pre-assembly when connection assembly 200 is established, the final assembly, which may take place later at a different location, is very simple and reliable.

Cable lug 95 is then pressed onto pin 70 by a press-on member 60 which comprises a nut 83 and a manipulation section 82 connected thereto. For this purpose, pin 70 may have an external thread which is compatible with an internal thread of nut 83.

Manipulation section 82 may have a tool interface 84, for example, with a receptacle having a hexagonal cross section, for example, in order to enable manipulation by machine. Manipulation section 82 may consist in particular of an insulating material in order to enable reliable manipulation. Nut 83 may consist of mechanically stable material, for example, metal, and may be embedded in and connected to manipulation section 82 during an injection-molding step.

The connection assembly comprises seals 80, 81, 85 for sealing against dirt and liquids.

### REFERENCE NUMERALS

- 10: component
- 15: end on the housing side
- 16: stop surface
- 17: positioning section component
- 19: end on the cable side
- 20: attachment section
- 21: attachment element component
- 30: cable clamping section
- 31: clamping tongue
- 32: clamping projection
- 33: outer wall
- 34: guide groove
- 35: cable tunnel
- 36: breakthrough
- 37: depth
- 38: guide strip
- 39: free end
- 40: clamping element
- 41: cable tie
- 50: housing member
- 51: attachment element housing member
- 52: latching projection
- 55: chamber
- 57: positioning section housing member
- 59: cable receptacle
- 60: press-on member
- 70: pin
- 80: seal
- 81: seal
- 82: manipulation section
- 83: nut
- 84: tool receptacle
- 85: seal
- 90: cable
- 91: conductor
- 92: sheath
- 95: cable lug
- 96: opening
- 97: crimping section
- 100: housing assembly
- 200: connection assembly
- 201: adjustment state
- 202: clamping state
- A: axial direction
- K: cable receiving direction
- R: radial direction
- S: pin receiving direction
- U: circumferential direction

## Claims

1. Component (10) for attaching a cable (90) to a housing member (50) comprising an attachment section (20) with at least one attachment element (21) and a tubular cable clamping section (30) that is connected integrally to said attachment section (20) and that forms a cable tunnel (35), wherein said cable clamping section (30) comprises at least one clamping tongue (31) that is configured to be deflected into said cable tunnel (35).

2. Component (10) according to claim 1, wherein said clamping tongue (31) comprises an inwardly directed clamping projection (32).

3. Component (10) according to claim 1 or 2, wherein said clamping tongue (31) on an outer side comprises a guide groove (34) extending along a circumferential direction (U) of said cable clamping section (30).

4. Component (10) according to one of the claims 1 to 3, wherein said clamping tongue (31) is configured to be manipulated from the exterior.

5. Component (10) according to one of the claims 1 to 4, wherein a radial cross section of said clamping section (30) in the region of said clamping tongue (31) is configured to deflect said clamping tongue (31) inwardly at most by a predefined value when said clamping element (40) is attached.

6. Component (10) according to one of the claims 1 to 5, wherein said clamping tongue (31) is deflected inwardly at most by a predefined value when it forms a circular outer circumference with the remainder of said cable clamping section (30).

7. Component (10) according to one of the claims 1 to 6, wherein said cable clamping section (30) comprises a breakthrough (36) which frames said clamping tongue (31).

8. Component (10) according to one of the claims 1 to 7, wherein said clamping tongue (31) runs parallel to an axial direction (A).

9. Component (10) according to one of the claims 1 to 8, wherein said clamping tongue (31) is oriented with a free end (39) towards an end (19) of said component (10) on the cable side.

10. Component (10) according to one of claims 1 to 9, wherein said cable tunnel (35) has a substantially cylindrical cross section.

11. Component (10) according to one of the claims 1 to 10, wherein said attachment element (21) is a latching element.

12. Component (10) according to one of the claims 1 to 11, wherein said component (10) has an inner stop surface (16) extending perpendicular to an axial direction (A).

13. Housing assembly (100), comprising a component (10) according to one of the claims 1 to 12 and a housing member (50) with a chamber (55) and a cable receptacle (59) connected to said chamber (55), wherein said cable receptacle (59) is configured to be connected to said component (10).

14. Connection assembly (200), comprising a housing assembly (100) according to claim 13 and a cable (90), wherein one end of said cable (90) is provided with a cable lug (95) and is arranged in said housing assembly (100).

15. Connection assembly (200) according to claim 14, wherein an opening (96) of said cable lug (95) is centered in said chamber (55) and wherein said connection assembly (200) comprises a clamping element (40) which clamps said cable (90) by way of said clamping tongue (31).
